Europäisches Patentamt

(19) European Patent Office

Office européen des brevets

(11) Publication number : **0 325 606 B1**

(12) **EUROPEAN PATENT SPECIFICATION**

(45) Date of publication of patent specification :
07.09.94 Bulletin 94/36

(51) Int. Cl.⁵ : **H01L 31/18**

(21) Application number : **87906613.2**

(22) Date of filing : **07.07.87**

(86) International application number :
**PCT/US87/01622**

(87) International publication number :
**WO 89/00341 12.01.89 Gazette 89/02**

(54) **METHOD OF FABRICATING SOLAR CELLS WITH ANTI-REFLECTION COATING.**

(43) Date of publication of application :
02.08.89 Bulletin 89/31

(45) Publication of the grant of the patent :
07.09.94 Bulletin 94/36

(84) Designated Contracting States :
**BE CH FR LI NL SE**

(56) References cited :
JP-A- 5 630 770
JP-A-58 151 070
US-A- 4 451 969
US-A- 4 640 001
EIGHTEENTH IEEE PHOTOVOLTAIC SPECIAL-
ISTS CONFERENCE, Las Vegas, Nevada, 21st
- 25th October 1985, pages 1008-1013, IEEE,
New York, US; S.R. WENHAM et al.:
"Efficiency improvement in screen printed
polycrystalline silicon solar cells by plasma
treatments"

(56) References cited :
JAPANESE JOURNAL OF APPLIED PHYSICS.
SUPPLEMENTS, vol. 21, suppl., February 1982,
pages 47-51, Tokyo, JP; H. MORITA et al.:
"Efficiency improvement of solar cell utilizing
plasma-deposited silicon nitride"
Solar Cells, vol. 14, issued May 1985, E. Cour-
celle et al. : "The Use of H2 and NH3 Ion
Implantation in the paasivation of defects in
silicon ribbon grown by the ribbon-against-
drop technique", pages 157-166.

(73) Proprietor : **MOBIL SOLAR ENERGY
CORPORATION**
Middlesex Technology Center
4 Suburban Park Drive
Billerica, MA 01821 (US)

(72) Inventor : **CHAUDHURI, Arup, R.**
35 Pleasant Street
West Concord, MA 02118 (US)
Inventor : **RAVI, Kramadhati, Venkata**
89 Fair Oaks Lane
Atherton, CA 94025 (US)

(74) Representative : **Thomson, Paul Anthony et al**
Potts, Kerr & Co.
15, Hamilton Square
Birkenhead Merseyside L41 6BR (GB)

## Description

This invention pertains to the manufacture of photovoltaic cells and more particularly to an improved method of fabricating silicon solar cells so as to enhance solar cell energy conversion efficiency.

## PRIOR ART

U.S. Patent No. 4451969, issued June 5, 1984 to Arup R. Chaudhuri for "Method of Fabricating Solar Cells", discloses a method of making semiconductor solar cells in which a layer of silicon nitride serves as a mask for metallization and also as an anti-reflection coating. A similar process is described in U.S. Patent No. 4640001, issued February 3, 1987 to Sakae Koiwai et al for "Solar Cell Manufacturing Method".

The Chaudhuri patent describes various steps pertaining to the manufacture of solar cells, including (1) formation of a shallow junction by phosphine diffusion in a silicon substrate, (2) formation of a "polysilazane" coating on the silicon substrate, (3) use of controlled heating to rapidly and efficiently accomplish (a) removal of photoresist used for the formation of grid electrode patterns by photolithography, and (b) conversion of the polysilazane to a substance that is more nearly silicon nitride ($Si_3N_4$) and has a substantially reduced etch rate, (4) application of an aluminum coating to the rear side of the substrate, and (5) heating the substrate so as to cause the aluminum to alloy with the silicon substrate so as to form an adherent ohmic contact. US Patent No. 4451969 indicates that the formation of polysilazane coating by a plasma reaction is well known. This document corresponds to the preamble of claim 1.

US Patent Nos. 4375007 and 4737197 suggest the concept of coating a silicone nitride layer with a metallic paste, and then firing the components so that the paste forms an electrically-conductive contact through the silicon nitride layer. US Patent No. 4737197 also teaches the concept of firing a silver paste through an anti-reflection coating to form a contact.

The document S.R. Wenham et al., Eighteenth IEEE Photovoltaic Specialist Conference, Las Vagas, 21-25 October 1985, pages 1008-1013 IEEE, New York relates to the concept of plasma processing to hydrogenate a silicon substrate for solar cells.

It is an object of the present invention to provide a new method of fabricating a photovoltaic solar cell that improves upon the methods disclosed in the prior art referred to above.

A more specific object of this invention is to provide an improved method for making semiconductor junction devices in which a silicon nitride-containing coating serves both as a mask to permit selective plating of a predetermined grid-shaped electrode on one side of the device and also as an anti-reflection coating.

Another object is to provide an improved method of manufacturing polycrystalline solar cells having an overall cell efficiency of about 12.5 to 16.0%, with the cells being characterized by a silicon nitride anti-reflection coating created by a plasma CVD process at a relatively high temperature.

A more specific object of the invention is to provide a process for manufacturing photovoltaic cells comprising an ammonia plasma treatment to produce hydrogen implantation in a silicon solar cell substrate, followed by a further treatment for implanting hydrogen and forming a thin coating of a polysilazane (a form of silicon nitride) having a relatively high etch rate.

Still another object of the invention is to provide an improved method of producing solar cells comprising (1) formation of an enhanced silicon nitride coating by (a) an ammonia plasma treatment that produces hydrogen implantation and (b) a combined silane and ammonia plasma treatment for obtaining additional hydrogen implantation and formation of a silicon nitride coating having a relatively high etch rate, (2) etching the silicon nitride coating to form a grid pattern, (3) coating the back surface of the substrate with an aluminum coating, and (4) heating the substrate so as to alloy the aluminum and densify the silicon nitride coating.

The foregoing objects are achieved by a method as outlined in the claims.

The ammonia and ammonia/silane plasma treatments ultimately have the effect of enhancing the conversion efficiency of the solar cell by virtue of diffusion of hydrogen into the substrate. The heat treatment for alloying the aluminum tends to cause the implanted hydrogen to diffuse further into the substrate, thereby beneficially altering the bulk diffusion length characteristics of the substrate so as to decrease recombination of the minority carriers produced in response to the incident light. The alloying heat treatment also tends to densify the polysilazane coating so that it is more nearly silicon nitride.

## BRIEF DESCRIPTION OF THE DRAWINGS

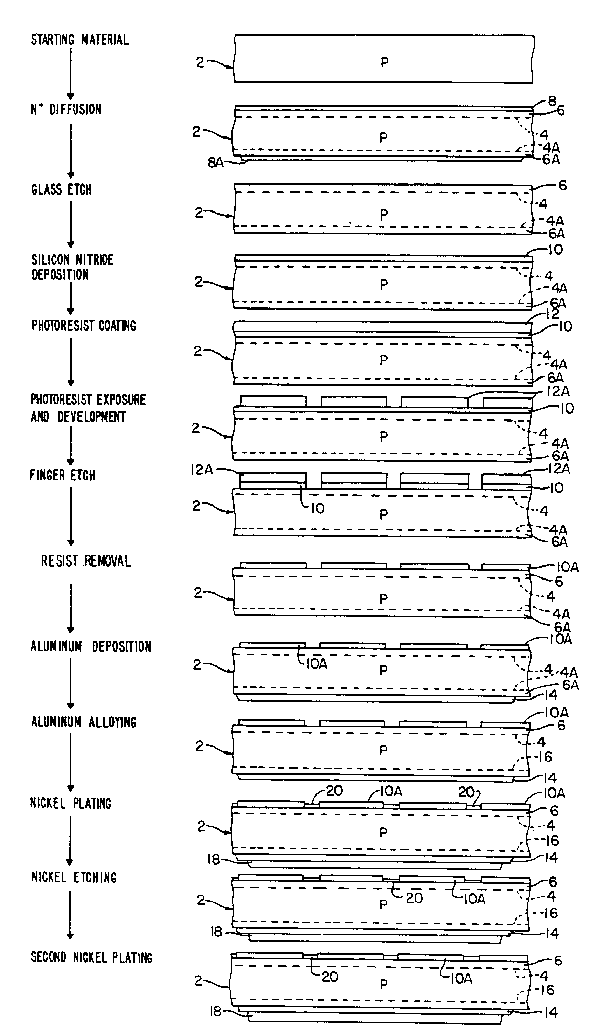

Other features and advantages of the invention are described or rendered obvious by the following detailed description which is to be considered together with the accompanying drawing which illustrates the steps involved in making solar cells according to a preferred form of the invention. In the drawing, the thicknesses and depths of the several coatings and regions are not shown exactly in accordance with their relative proportions, for convenience of illustration and description.

## DETAILED DESCRIPTION OF THE INVENTION

It has been discovered that it is possible to enhance the conversion efficiency of silicon photovoltaic solar cells of the type comprising a silicon substrate having a P/N junction and a silicon nitride anti-reflection coating by sequentially (a) subjecting the substrate to an ammonia plasma treatment at a selected temperature for a time sufficient to produce hydrogen implantation, and (b) thereafter subjecting the substrate to a silane and ammonia plasma treatment to obtain formation of a silicon and nitrogen-containing layer which may be deemed a silicon nitride but is more accurately identified as a coating of $Si_xH_yN_z$ (polysilazane), where x and z each range from about 1.0 to about 1.3 and y ranges from about .05 to about .30. Additional hydrogen implantation occurs during the combined ammonia/silane treatment.

The $Si_xH_yN_z$ coating is a dielectric layer which (a) can be easily and precisely etched away from the substrate in the form of a selected metallization pattern without any significant etching of silicon, (b) can serve as a mask to permit selected metal plating for formation of electrodes, and (c) can serve as an anti-reflection coating. More importantly, the hydrogen implantation resulting from the two-step plasma treatment enhances the conversion efficiency of the solar cell.

Referring now to the drawing, the preferred embodiment of the invention relates to the production of solar cells from EFG-grown P-type polycrystalline silicon ribbon. However, it is to be noted that the invention may be practiced using silicon ribbons or substrates produced by other methods, e.g., substrates produced from Czochralski (CZ) grown crystals.

As a first process requirement, a pre-cleaned silicon substrate in the form of a flat ribbon 2 is subjected to a phosphine diffusion calculated to produce a relatively shallow junction 4 at a first side (hereinafter the "front side") of the substrate, i.e., a junction of between about $3.0 \times 10^{-7}$ m and $5.0 \times 10^{-7}$ m (3000 and about 5000 Angstrom units deep), an N-type conductivity region 6, and a phosphosilicate glass 8. In this preferred embodiment of the invention, the other side (the "rear side") of the substrate is not masked off during the diffusion step, with the result that a second junction 4A of substantially like depth, another N-type conductivity region 6A, and a layer of phosphosilicate glass 8A are produced on that other side of the substrate. The diffusion is terminated by a furnace slow cooling step which serves as a gettering treatment to getter impurities at the surface of the ribbon where they can be moved by etching.

Preferably the phosphine diffusion step is carried out at a temperature of between about 800 degrees C and 1000 degrees C, and the gettering treatment involves cooling the ribbon substrate to a temperature of about 650 degrees over a period of between about 1.5 and about 3.0 hours. During the gettering treatment, the silicon substrate is typically exposed to an atmosphere of oxygen and nitrogen (preferably in about a 1:1 volume ratio) gas.

Next, the phosphosilicate glass layers 8 and 8A are etched away by immersing the substrate in, e.g., a buffered solution of $10NH_4F(40\%):1HF$ at a temperature of between about 25 degrees C and about 40 degrees C.

In the next step, the substrate is subjected to a two-step silicon nitride deposition process. The first step of the two-step process involves placing the substrate in a plasma reaction chamber, and subjecting the substrate to an ammonia plasma at a selected temperature for a time sufficient to produce hydrogen implantation. Thereafter the substrate is maintained in the plasma reaction chamber and subjected to a mixed plasma of ammonia and silane at a selected temperature for a time sufficient to produce additional hydrogen implantation and a polysilazane coating of suitable thickness on the silicon. In this two-step silicon nitride deposition process, hydrogen is implanted via the front surface of the substrate through the shallow junction 4.

The two-step silicon nitride (polysilazane) deposition process is preferably carried out using a conventional parallel-plate-electrode plasma-enhanced CVD apparatus.

More specifically, the two-step polysilazane process preferably involves the following steps: (1) loading the substrates onto the electrode surface(s) (2) with the substrates in the chamber, heating the vacuum chamber to a selected temperature, (3) evacuating the chamber to a pressure of about 0.2 Torr or lower, (4) introducing ammonia gas to the vacuum chamber at a selected rate for at least about 15 seconds to equilibrate the pressure at about 1-2 Torr, (5) turning on RF power to the electrodes to produce an ammonia plasma, (6) after the RF power has equilibrated (usually within about 6 to 12 seconds), continuing ammonia plasma production for a period of time sufficient to produce implantation of hydrogen in the substrate, (7) introducing silane gas to the vacuum chamber while maintaining flow of ammonia gas, and (8) terminating RF power and ammonia and silane gas flow after a polysilazane coating of sufficient thickness has been formed on the substrate.

As used herein, the term "polysilazane" means a form of hydrogenated silicon nitride having a composition represented by the formula $Si_xH_yN_z$, where Si, N and H are silicon, nitrogen and hydrogen respectively, and x and z each range from about 1.0 to about 1.3, and y ranges from about .05 to about .30. This polysilazane ("silicon nitride") coating 10 differs from the polysilazane coating initially formed in the deposition process described in the Chaudhuri patent in that it is denser and its hydrogen content varies from about 5 to about 30 atomic percent, depending on the temperature at which it is formed. It has an etch rate of about 4.0 to 10.0·$10^{-9}$ m/minute (40 to 100 Angstrom units/minute) in a buffered oxide etch such as a solution of HF and $NH_4F$, and is deposited in a relatively thin layer, i.e., between about 5.0 and 15.0 x $10^{-8}$m (500 and about 1500 Angstroms) thick.

The 2-step silicon nitride deposition process is conducted with the plasma reaction chamber heated to a temperature of between about 320 degrees C and 500 degrees C, and with the electrodes energized by an RF power supply preferably having a frequency in the range of 35 kilohertz to 450 kilohertz. 300 watts to 800 watts of RF power is provided into the plasma discharge that is established in the gaps between the pairs of electrodes. The two-step process, i.e., steps (6) and (7) above, takes between about 3.0 to about 20 minutes to complete, with only ammonia and silane being introduced to the reactor.

Following completion of the 2-step silicon nitride deposition process, the next step involves coating the front side of the substrate with a negative photoresist 12 in a suitable manner, e.g., by spraying. In the usual case, the photoresist is baked to drive off organic solvents in the resist. Typically, the baking is achieved by heating the photoresist to between 80 degrees and 100 degrees C or between about 30 and about 60 minutes.

Then the photoresist is exposed to a suitable radiant energy source through a suitable grid pattern mask so that exposed portions of the resist will polymerize. The electrode pattern typically is similar to the multi-fingered pattern shown in U.S. Patent No. 3686036. Then the resist is developed by contacting it with one or more suitable solutions, e.g., toluene and/or propanol, which serve to remove the unexposed portion of the resist, leaving the exposed portions 12A intact.

Next the substrate is subjected to a suitable buffered oxide etch such as a buffered solution of $10NH_4F(40\%)$:$1HF$, so as to etch away the nitride in those regions where the resist has been removed and also to clean the rear side of the substrate.

The next step is removal of the remaining resist by contacting the substrate with a reactive solution that digests the resist without attacking the substrate.

Then the rear side of the substrate is coated with a layer 14 of a selected aluminum-containing paste 14 that preferably comprises aluminum powder in an organic vehicle which can be removed by volatilization or pyrolysis. This step is then followed by a second heating step. In this second heating step, the substrate is heated for about 0.5-2.0 minutes at a temperature of between about 700-800 degrees C to remove any volatile or pyrolyzable organic components of the paste and also to alloy the aluminum in the paste to the silicon substrate. This alloying step causes the aluminum coating to alloy with the rear side of the substrate so as to convert the N-type region 6A to a P+ region 16 having a depth of between about 1 to about 3 microns. This same heating step has the effect of converting the polysilazane-type silicon nitride into a form of silicon nitride which is more nearly $Si_3N_4$ and denser and has a much slower etch rate than as originally deposited, typically about 20 or less Angstrom units/per minute. The heating step also tends to drive the hydrogen further into the substrate. This improves the bulk characteristics of the substrate by decreasing recombination of the minority carriers produced in response to the incident light.

At the end of the foregoing heating step, the substrate is treated to make the front surface exposed silicon pattern and the back surface aluminum solderable, for example by plating both sides of the substrate with nickel, with the nickel layer 18 on the back side being applied over the entire area of the aluminum layer 14 and the nickel layer 20 on the front side being applied over those areas of the front surface of the substrate from which the silicon nitride coating has been removed. Nickel is not deposited on the densified silicon nitride coating 10A remaining on the front side of the substrate. Plating of the nickel layers may be done in various ways. Preferably it is accomplished in accordance with a known electroless nickel plating process, e.g., a process of the type described in U.S. Patent No. 4321283 of Kirit Patel et al.

After the nickel has been applied, the substrate is heated in nitrogen or hydrogen to a temperature and for a time sufficient to sinter the nickel layers and cause the nickel layer 20 on the front side of the substrate to react with the adjacent silicon to form a nickel silicide ohmic contact. Preferably the substrate is heated to a temperature of about 300 degrees C for between about 15 and about 40 minutes. This provides a nickel silicide layer with a depth of about 300 Angstrom units. The nickel layer 18 on the rear side forms an alloy with the aluminum layer.

After sintering has been completed, the nickel is subjected to etching with nitric acid to remove excess nickel from both sides of the substrate. The densified silicon nitride film 10A is highly resistant to the nickel etch solution and thus serves as a mask to protect the underlying silicon when excess nickel is etched away.

Thereafter the nickel silicide and nickel/aluminum alloys are further metallized to provide suitable conducting contacts. Preferably but not necessarily, this further metallization involves application of a second layer of nickel to the nickel layers on both sides of the substrate according to one of the methods known in the art. Immediately thereafter, one or more layers of copper are applied to the exposed nickel on both sides of the substrate so as to bond to the nickel layers and thereby protect them against oxidation. The copper may be applied by electrolytic plating. Thereafter the device may be subjected to other known treatments for known purposes, e.g., a layer of tin and solder may be applied successively over the previously applied metal layers.

The nickel etch removes excess nickel and also some of the nickel aluminum alloy formed on the rear side of the substrate during the sintering step. After the nickel etch step, the front side of the substrate is characterized by a nickel silicide along the entire expanse of the preselected electrode grid pattern, and an aluminum/nickel alloy layer overlying an aluminum electrode layer on the rear side of the substrate.

The silicon nitride remaining on the front side of the substrate serves as an effective anti-reflection coating.

Tests have demonstrated that the best conversion efficiencies are achieved when the ammonia and the ammonia/silane plasma treatments are carried out at a temperature of 320-500 degrees C. Test also have shown that the best efficiencies are obtained when ammonia plasma treatment is carried out for between 1 and 15 minutes, and preferably between 1.5 and 10 minutes, before the combined ammonia/silane plasma treatment is initiated. While the ammonia plasma treatment may be carried out for more than 15 minutes, no further improvement in efficiency will result.

The ammonia gas is preferably supplied undiluted to the reactor. The rate of flow of ammonia depends upon the volume of the reactor chamber, but in any event should be enough to assure that a plasma can be sustained under the applied RF field and adequate hydrogen implantation occurs. The rate of flow of silane is preferably maintained so as to provide between about 5:1 to about 10:1 ammonia to silane volume flow ratio.

The ammonia/silane plasma treatment should be conducted for between 1.0 to about 4 minutes, preferably about 2.5 minutes, so as to get a polysilazane layer with a thickness between about 840 and about 890 Angstroms. Thicknesses in this range are required for optimum anti-reflection properties of the polysilazane layer after it has been heat treated. The densified silicon nitride has a refractive index of 2.15.

Following is a specific example of the preferred mode of practicing the invention.

## EXAMPLE

A subtrate in the form of a silicon ribbon of P-type conductivity made by the EFG process, and having a conductivity of about 2 to 3 ohm-cm., is cleaned by etching it in a solution of $HNO_3:HF(1:1)$ for about 3 minutes at a temperature of about 25 degrees C. Thereafter the ribbon is placed in a diffusion furnace exposed to a continuous flow of an atmosphere comprising oxygen, nitrogen and a phosphorus source (such as $PH_3$) at a temperature of about 900 degrees C for a period of approximately 30 minutes. Thereafter the flow of phosphine is terminated and the furnace is allowed to cool in an air (oxygen and nitrogen) atmosphere to a temperature of about 650 degrees C over a period of about 1.5 hours, after which it is removed from the furnace.

In the diffusion furnace, the following reactions occur:

$$Si(s) + O_2(g) \rightarrow SiO_2(s)$$
$$2PH_3(g) + 4O_2(g) \rightarrow P_2O_5 (g) + 3H_2O(g)$$
$$P_2O_5(g) + SiO_2(s) \rightarrow (P_2O_5)_x(SiO_2)_y(s)$$
$$2P_2O_5(s) + 5Si(s) \rightarrow 4P(s) + 5SiO_2(s)$$

where (g) and (s) indicate gaseous and solid states respectively.

The $(P_2O_5)_x(SiO_2)_y$ is a phosphosilicate glass. It is removed from both sides of the ribbon by submerging the latter in a buffered HF acid solution, e.g., $10NH_4 F(40\%):1HF$, for a period of about 2 minutes.

Thereafter the ribbon substrate is placed in the plasma reaction chamber of a conventional parallel-plate-electrode plasma-enhanced CVD apparatus, and the substrate is subjected to the two-step silicon nitride deposition process in the reactor chamber. The reactor chamber is evacuated to a pressure level of about 0.2 Torr and maintained there in a gaseous $N_2$ ambient while being heated to a temperature of 360 degrees C. Then ammonia gas is fed into the reactor to provide a pressure of approximately 1 Torr. When the pressure in the reactor chamber has equilibrated, the RF power supply is turned on to establish a plasma discharge through the ammonia gas. The RF power supply is operated at 150 kilohertz and is set to deliver about 580 watts average RF power to the plasma. Then, about 10 minutes later and with ammonia gas still flowing through the vacuum reaction chamber at its original rate, silane gas is introduced to the reactor so as to give approximately a 10:1 volume ratio between the ammonia and silane gases. The average RF power input is maintained at about 580 watts. After about an additional 2.8 minutes has elapsed, the RF power supply is shut off and the gas flow is terminateed. After the reactor chamber has been restored to ambient pressure, the ribbon substrate is removed from the reactor chamber. It has a polysilazane coating of about 850 Angstroms thick.

Thereafter a layer of a negative photoresist is applied to the front side of the ribbon. A preferred negative resist is marketed under the name of Dynachem. The photoresist is prebaked for about 40-60 minutes at a temperature of 80-90 degrees C so as to cause it to adhere firmly to the silicon. This photoresist layer is then covered with a mask in the pattern of a multi-fingered grid electrode, e.g. an electrode having the form illustrated in U.S. Patent No. 3686036. The grid mask is then irradiated with ultraviolet light for approximately 3 seconds so as to cause the illuminated portion of the photo-resist coating to polymerize. The photoresist is then developed by contact with toluene and/or propanol and/or other suitable chemicals. This development process removes those portions of the resist which have not been irradiated and hence have not polymerized.

After development of the resist, the ribbon is subjected to a buffered oxide etch consisting of a solution of HF and $NH_4F$. The etchant etches away the nitride on those portions of the front surface of the ribbon from which the resist has been removed. The silicon nitride has an etch rate of approximately 100 Angstroms per minute.

Thereafter the silicon ribbon is immersed in a sulfuric acid bath for about 3 minutes to strip away the remaining photoresist. The substrate is then washed with water and dried.

After removal of the remaining resist, the back side of the ribbon is coated with an aluminum paste comprising minute aluminum particles in a volatile organic vehicle that preferably is terpineol. The paste is applied as a relatively thin layer. Then the substrate is subjected to infra-red heating at a temperature of about 700-800 degrees C for about 1.0 minute to remove the organic component of the aluminum paste and alloy the remaining aluminum to the silicon. This alloying step causes the N-type region at the rear side of the ribbon to be converted to a P+ region 16 having a depth of about 1-3 μm. It also densifies the silicon nitride and gives it a refractive index of 2.15

Thereafter both sides of the silicon ribbon are coated with a layer of nickel in accordance with the method described in said U.S. Patent No. 4321283. More specifically, both sides of the silicon ribbon are coated with a layer of nickel by immersing the ribbon in an aqueous bath of nickel chloride and ammonium fluoride at a pH of about 2.9 and approximately room temperature for about 2-4 minutes. Then the ribbon is subjected to sintering in a furnace at a temperature of about 300 degrees C in a nitrogen atmosphere for a period of about 25 minutes, whereby the nickel layer 20 on the front side of the ribbon reacts with the adjacent exposed silicon to form a nickel silicide ohmic contact, and nickel layer 18 on the back side forms an alloy with the underlying aluminum layer 14. It is to be noted that no nickel layer is deposited on the silicon nitride remaining on the front side of the ribbon.

The ribbon is then immersed in an etching solution consisting of $HNO_3$ and kept there for a period of approximately 1-2 minutes so as to remove excess nickel from both sides of the ribbon. On removal from this bath the nickel on the front side of the ribbon is essentially all in the form of a nickel silicide.

After removal from the nickel etchant the ribbon is again subjected to ultrasonic cleaning in water to remove all residues. Then a second nickel plating composition is applied to the metallized portions of both sides of the ribbon according to the method described above for the initial nickel plating.

As soon as possible after the second nickel plating step has been completed, a layer of electroless copper is applied to the metallized portions of the two sides of the ribbon. This is followed by a second layer of electrolytically deposited copper applied to the metallized portions of both sides of the ribbon. Then a layer of tin is electrolytically deposited onto each copper layer by immersing the ribbon in an electrolytic tin bath.

Thereafter the finished cell is dipped in a solder bath comprising 62% tin, 36% lead and 2% silver so as to apply a solder layer over the tin coatings.

It has been determined that solar cells made according to the foregoing example from EFG grown ribbons routinely exhibit conversion efficiencies in the range of 12.5%-16%. The silicon nitride remaining on the front side of the finished devices serves as an effective anti-reflection coating.

As has been previously noted, in order to combine the advantages of (1) a high performance junction formation technique involving phosphine diffusion so as to create a shallow junction plus a furnace cool for gettering purposes, and (2) a low cost-metallization technique, a dielectric is required which can serve as a mask to provide selective plating without degrading cell performance. The plasma-deposited silicon nitride meets that requirement and also offers the added advantages that it is a very effective anti-reflection coating and the process of producing that coating and alloying the aluminum beneficially alters the bulk diffusion length characteristics. Without the heat treatment provided by the alloying step, an improvement in bulk diffusion length is not discernable. This invention offers the added advantage that no separate heat treatment is required to densify the silicon nitride coating.

This invention retains a number of the advantages of the process described in U.S. Patent No. 4451969, i.e, the silicon nitride coating is deposited, rather than formed by conversion of a heavily doped, i.e., high conductivity, N+ silicon, as occurs, for example, when an anti-reflection coating is formed by chemical staining which converts silicon to an oxide fluoride stain A/R coating or when a silicon nitride anti-reflection coating is formed by thermal nitridation (see U.S. Patent No. 4266985 for formation of direct thermal nitride films).

Of course, the process provided by this invention is not limited to the production of solar cells from EFG substrates. Thus, for example, silicon substrates derived from CZ grown boules or grown from the melt by a method other than EFG also may be used to form relatively high efficiency solar cells according to the present invention. Also the invention may be applied to silicon substrates which are not ribbons or are not flat, e.g., circular pieces of silicon, or silicon in forms having an arcuate or polygonal cross-sectional shape.

The process steps herein described may be used in the manufacture of other kinds of semiconductor devices.

A further obvious modification is to mask the rear side of the substrate during the diffusion junction formation step, so as to prevent formation of back junction 4A and the N-type region 6A. In such case a P+ region as shown at 16 is still produced when the aluminum layer 14 is alloyed to the silicon substrate.

It also is understood that the etching of the polysilazane coating to form a grid electrode pattern may be achieved without photolithography, e.g., by use of plasma or laser etching techniques.

Still other changes may be made without departing from the principles of the invention, e.g., forming the P+ back region of the cell by using flame sprayed aluminum instead of an aluminum paint, or using different methods of applying the second and subsequent coatings of nickel and/or coating(s) of copper, or forming the junction by ion implantation. Also it is contemplated that silver or other conducting and solderable metals may be used in place of nickel to form an ohmic contact. Further the method of this invention may be practiced using various types of conventional parallel-plate-electrode plasma-enhanced CVD machines.

## Claims

1. A method of fabricating a photovoltaic solar cell comprising the steps of providing a silicon substrate (2) having first and second opposite surfaces, forming a P/N junction (4) in the substrate adjacent to the first surface, forming a polysilazane coating (10) on the first surface by a plasma reaction and forming electrical contacts (10,14) on the first and second surfaces, with the first contact (20) extending through and being flanked by said polysilazane coating, said coating being etched so as to form a two-dimensional pattern for said first contacts, characterized in that before the electrical contacts are formed the first surface is subjected sequentially to an ammonia plasma treatment long enough to produce hydrogen implantation and a combined silane and ammonia plasma treatment long enough to produce additional hydrogen implantation and formation of a polysilazane coating and, after the plasma treatment, an aluminum-containing coating (14) is applied to the second opposite surface and the substrate (10) is heated to a temperature and for a time sufficient to cause the aluminum constituent of the aluminum-containing coating (14) to alloy with the silicon substrate and thereby form an aluminum electrical contact at the second surface and to drive the implanted hydrogen deep into the substrate.

2. A method according to claim 1, characterized in that after the substrate is heated to cause alloying of aluminum the polysilazane coating has a refractive index of 2.15.

3. A method according to claim 1 or 2, characterized in that the polysilazane coating has a thickness of between $8.4 \times 10^{-8}$ m and $8.9 \times 10^{-8}$ m (840 and 890 Angstroms) after the sequential plasma treatments.

4. A method according to any preceding claim, characterized in that after the sequential plasma treatments the polysilazane is covered with an adherent coating of a photoresist material, the photoresist coating being exposed to radiant energy through a mask defining a predetermined two-dimensional pattern, the photoresist is chemically developed so that selected portions of the resist are removed from the polysilazane coating according to the predetermined pattern and those portions of the polysilazane coating which are not covered by the photoresist are removed so that selected portions of the first surface are exposed to the atmosphere and the conductive metal is applied to the selected portions of the first surface.

5. A method according to claim 1 or 4, characterized in that the metal applied to the selected portions of the first surface is silver or nickel.

6. A method according to claim 1 or 4, characterized in that a solderable metal is applied to the selected portions of the first surface and the solderable metal is sintered so that the solderable metal and the silicon of the substrate react to form a solderable metal silicide at their interface.

7. A method according to any preceding claim, characterized in that the substrate is subjected to ammonia plasma at a temperature of between 320° C and 500° C for between 1 and 15 minutes.

8. A method according to any preceding claim, characterized in that the silane/ammonia plasma treatment is conducted for between 1.0 and 4.0 minutes at a temperature of between 320° C and 500° C.

9. A method according to any preceding claim, characterized in that the ammonia plasma treatment and the silane and ammonia plasma treatment are carried out in the same plasma reaction chamber.

10. A method according to any preceding claim, characterized in that the polysilazane coating is represented by the formula $Si_xH_yN_z$ where Si, H and N are silicon, hydrogen and nitrogen respectively and x and z each range from about 1.0 to about 1.3 and y ranges from about 0.05 to about 0.30.

11. A method according to any preceding claim, characterized in that the sequential plasma treatments are carried out using an RF frequency of 35 to 450 kilohertz.

12. A method according to claim 11, characterized in that the sequential plasma treatment is carried out using 300 to 800 watts of RF power supplied to the electrodes of the plasma reaction chamber.

13. A method according to any preceding claim, characterized in that the plasma treatments are carried out using an RF frequency of 150 kilohertz, the substrate being exposed to ammonia plasma for at least about 1.0 minute and the substrate being exposed to a combined silane and ammonia plasma for about 2.8 minutes.

14. A method according to any preceding claim, characterized in that the polysilazane coating has a relatively fast etch rate in a buffered oxide etch such as a solution of HF and $NH_4F$ before it is heated and a relatively slow etch rate in the same buffered oxide etch after it has been heated.

15. A method according to claim 14, characterized in that the polysilazane coating has an etch rate of $4.0 \times 10^{-9}$ to $10.0 \times 10^{-9}$ m/minute (40 to 100 Angstrom units/minute) in the buffered oxide etch before it has been heated and an etch rate of $2.0 \times 10^{-9}$ or less m/minute (20 or less Angstrom per minute) after it has been heated.

## Patentansprüche

1. Verfahren zur Herstellung eines Fotoelements mit folgenden Schritten:
   - es wird von einem Siliziumsubstrat (2) mit einer ersten Fläche und einer entgegengesetzten zweiten Fläche ausgegangen,
   - es wird ein P/N-Übergang (4) in der Nähe der ersten Fläche im Substrat gebildet,
   - es wird eine Polysilazanschicht (10) auf der ersten Fläche mittels einer Plasmareaktion gebildet,
   - es werden elektrische Kontakte (10, 14) auf der ersten und zweiten Fläche gebildet, wobei der erste Kontakt (20) durch die Polysilazanschicht geht und von dieser Schicht seitlich eingefaßt wird und wobei diese Schicht derart geätzt wird, daß ein zweidimensionales Muster für die ersten Kontakte gebildet wird,
   **dadurch gekennzeichnet**, daß vor der Bildung der elektrischen Kontakte zunächst der erste Kontakt einer Ammoniakplasmabehandlung unterzogen wird, die zeitlich zur Erzeugung einer Wasserstoffimplantation und zur Bildung einer Polysilazanschicht ausreicht, und daß nach der Plasmabehandlung dann eine Aluminium enthaltende Schicht (14) auf die zweite Fläche aufgebracht wird und schließlich das Substrat (10) auf eine solche Temperatur und für eine solche Dauer erhitzt wird, die ausreichen, um das Aluminium der Aluminium enthaltenden Schicht (14) mit dem Siliziumsubstrat zu legieren und dabei einen elektrischen Aluminiumkontakt auf der zweiten Fläche zu bilden und den implantierten Wasserstoff tief ins Substrat zu befördern.

2. Verfahren nach Anspruch 1, dadurch gekennzeichnet, daß nach der zum Legieren des Aluminiums vorgenommenen Erhitzung des Substrats die Polysilazanschicht eine Brechungszahl von 2,15 hat.

3. Verfahren nach Anspruch 1 oder 2, dadurch gekennzeichnet, daß die Polysilazanschicht eine Dicke zwischen $8,4 \cdot 10^{-8}$ und $8,9 \cdot 10^{-8}$ (840 und 890 Angström) nach den aufeinanderfolgenden Behandlungen aufweist.

4. Verfahren nach einem der vorhergehenden Ansprüche, dadurch gekennzeichnet, daß nach den aufeinanderfolgenden Plasmabehandlungen das Polysilazan mit einer Haftschicht aus einem Fotoabdeckmaterial beschichtet wird, wobei die Fotoabdeckschicht einer Strahlungsenergie durch eine Maske ausgesetzt wird, die ein vorbestimmtes, zweidimensionales Muster festlegt, und die Fotoabdeckung chemisch entwickelt wird, so daß ausgewählte Teile der Abdeckung gemäß dem vorbestimmten Muster aus der Polysilazanschicht und die nicht von der Fotoabdeckung bedeckten Teile der Polysilazanschicht beseitigt werden, so daß ausgewählte Teile der ersten Fläche der Atmosphäre ausgesetzt werden, und daß leitendes Metall an den ausgewählten Teilen der ersten Fläche aufgebracht wird.

5. Verfahren nach Anspruch 1 oder 4, dadurch gekennzeichnet, daß das auf die ausgewählten Teile der ersten Fläche aufgebrachte Metall Silber oder Nickel ist.

6. Verfahren nach Anspruch 1 oder 4, dadurch gekennzeichnet, daß ein lötbares Metall auf die ausgewählten Teile der ersten Fläche aufgebracht wird, und daß dies Metall gesintert wird, so daß das lötbare Metall und das Silizium des Substrats so reagieren, daß ein lötbares Metallsilicid an der Grenzfläche gebildet wird.

7. Verfahren nach einem der vorhergehenden Ansprüche, dadurch gekennzeichnet, daß das Substrat einem Ammoniakplasma bei einer Temperatur zwischen 320°C und 500°C für die Dauer von 1 bis 15 Minuten ausgesetzt wird.

8. Verfahren nach einem der vorhergehenden Ansprüche, dadurch gekennzeichnet, daß die Silan-Ammoniak-Plasmabehandlung für die Dauer von 1 bis 4 Minuten bei einer Temperatur zwischen 320°C und 500°C ausgeführt wird.

9. Verfahren nach einem der vorhergehenden Ansprüche, dadurch gekennzeichnet, daß die Ammoniakplasmabehandlung und die Silan- und Ammoniakplasmabehandlung in derselben Plasmareaktionskammer vorgenommen werden.

10. Verfahren nach einem der vorhergehenden Ansprüche, dadurch gekennzeichnet, daß die Polysilazanschicht nach der Formel $Si_xH_yN_z$ zusammengesetzt ist, wobei Si Silizium, H Wasserstoff und N Stickstoff ist und x und y jeweils im Bereich von etwa 1,0 bis etwa 1,3 liegen und y im Bereich von etwa 0,05 bis etwa 0,30 liegt.

11. Verfahren nach einem der vorhergehenden Ansprüche, dadurch gekennzeichnet, daß die aufeinanderfolgenden Plasmabehandlungen unter Benutzung einer Radiofrequenz von 35 bis 450 kHz ausgeführt werden.

12. Verfahren nach einem der vorhergehenden Ansprüche, dadurch gekennzeichnet, daß die aufeinanderfolgenden Plasmabehandlungen unter Benutzung einer Radiofrequenzleistung von 300 bis 800W ausgeführt wird, die den Elektroden der Plasmareaktionskammer zugeführt wird.

13. Verfahren nach einem der vorhergehenden Ansprüche, dadurch gekennzeichnet, daß die Plasmabehandlungen unter Benutzung einer Radiofrequenz von 150 kHz ausgeführt werden, wobei das Substrat dem Ammoniakplasma für eine Dauer von mindestens etwa einer Minute und einem kombinierten Silan- und Ammoniakplasma für die Dauer von etwa 2,8 Minuten ausgesetzt wird.

14. Verfahren nach einem der vorhergehenden Ansprüche, dadurch gekennzeichnet, daß die Polysilazanschicht eine verhältnismäßig hohe Ätzgeschwindigkeit in einer gepufferten Oxidätzung wie beispielsweise in einer Lösung von HF und $NH_4F$ vor ihrer Erhitzung und eine verhältnismäßig niedrige Ätzgeschwindigkeit in derselben gepufferten Oxidätzung nach ihrer Erhitzung hat.

15. Verfahren nach Anspruch 14, dadurch gekennzeichnet, daß die Polysilazanschicht eine Ätzgeschwindigkeit $4 \cdot 10^{-9}$ bis $10 \cdot 10^{-9}$m pro Minute (40 bis 100 Angström pro Minute) in der gepufferten Oxidätzung vor ihrer Erhitzung und eine Ätzgeschwindigkeit von $2 \cdot 10^{-9}$m pro Minute oder weniger (20 Angström pro Minute oder weniger) nach ihrer Erhitzung hat.

## Revendications

1. Procédé de fabrication d'une cellule solaire photovoltaïque, comprenant les étapes consistant à prendre un substrat de silicium (2) ayant des première et deuxième surfaces opposées, à former une jonction PN (4) dans le substrat, adjacente à la première surface, à former un revêtement de polysilazane (10) sur la première surface par une réaction au plasma et à former des contacts électriques (10, 14) sur les première et deuxième surfaces, le premier contact (10) s'étendant à travers ledit revêtement de polysilazane et étant flanqué de celui-ci, ledit revêtement étant attaqué chimiquement de manière à former un motif bidimensionnel pour lesdits premiers contacts, caractérisé en ce que, avant que les contacts électriques ne soient formés, la première surface est soumise successivement à un traitement au plasma à l'ammoniaque suffisamment long pour produire une implantation d'hydrogène et à un traitement combiné au plasma et au silane à l'ammoniaque suffisamment long pour produire une implantation d'hydrogène supplémentaire et la formation d'un revêtement de polysilazane et, en ce que, après le traitement au plasma, un revêtement contenant de l'aluminium (14) est appliqué sur la deuxième surface opposée, et en ce que le substrat (10) est chauffé à une température et pendant un durée suffisantes pour amener le constituant aluminium du revêtement contenant de l'aluminium (14) à s'allier avec le substrat de silicium pour ainsi former un contact électrique à l'aluminium sur la deuxième surface et faire pénétrer profondément dans le substrat l'hydrogène implanté.

2. Procédé selon la revendication 1, caractérisé en ce que, après que le substrat a été chauffé pour provoquer l'alliage de l'aluminium, le revêtement de polysilazane a un indice de réfraction de 2,15.

3. Procédé selon la revendication 1 ou 2, caractérisé en ce que le revêtement de polysilazane a une épaisseur située entre $8,4 \times 10^{-8}$ m et $8,9 \times 10^{-8}$

(840 et 890 angströms) après les traitements au plasma successifs.

4. Procédé selon l'une quelconque des revendications précédentes, caractérisé en ce que, après les traitements au plasma successifs, le polysilazane est recouvert d'un revêtement adhérent en un photorésist, la couche de photorésist étant exposée à une énergie rayonnante par l'intermédiaire d'un masque définissant un motif bidimensionnel prédéterminé, le photorésist est développé chimiquement afin que des parties sélectionnées du résist soient éliminées du revêtement de polysilazane selon le motif prédéterminé et que les parties du revêtement de polysilazane qui ne sont pas recouvertes par le photorésist soient éliminées, de telle manière que des parties sélectionnées de la première surface soient exposées à l'atmosphère et que le métal conducteur soit appliqué sur les parties sélectionnées de la première surface.

5. Procédé selon la revendication 1 ou 4, caractérisé en ce que le métal appliqué sur les parties sélectionnées de la première surface est l'argent ou le nickel.

6. Procédé selon la revendication 1 ou 4, caractérisé en ce qu'un métal brasable est appliqué sur les parties sélectionnées de la première surface et en ce que le métal brasable est fritté afin que le métal brasable et le silicium du substrat réagissent pour former un siliciure métallique brasable à leur interface.

7. Procédé selon l'une quelconque des revendications précédentes, caractérisé en ce que le substrat est soumis à un plasma à l'ammoniaque à une température située entre 320° C et 500° C pour une durée allant d'1 à 15 minutes.

8. Procédé selon l'une quelconque des revendications précédentes, caractérisé en ce que le traitement au plasma au silane/à l'ammoniaque est effectué pendant 1,0 à 4,0 minutes à une température située entre 320° C et 500° C.

9. Procédé selon l'une quelconque des revendications précédentes, caractérisé en ce que le traitement au plasma à l'ammoniaque et le traitement au plasma au silane et à l'ammoniaque sont effectués dans la même enceinte de réaction au plasma.

10. Procédé selon l'une quelconque des revendications précédentes, caractérisé en ce que le revêtement de polysilazane est représenté par la formule $Si_xH_yN_z$, où si, H et N sont respectivement le silicium, l'hydrogène et l'azote et x et z sont chacun situés dans la fourchette allant d'environ 1,0 à environ 1,3 et y est situé dans la fourchette allant d'environ 0,05 à environ 0,30.

11. Procédé selon l'une quelconque des revendications précédentes, caractérisé en ce que les traitements au plasma successifs sont effectués en utilisant une fréquence radioélectrique de 35 à 450 kilohertz.

12. Procédé selon la revendication 11, caractérisé en ce que le traitement au plasma séquentiel est effectué en utilisant 300 à 800 watts d'énergie RF fournie aux électrodes de la chambre de réaction au plasma.

13. Procédé selon l'une quelconque des revendications précédentes, caractérisé en ce que les traitements au plasma sont effectués en utilisant une fréquence radioélectrique de 150 kilohertz, le substrat étant exposé au plasma à l'ammoniaque pendant au moins environ 1,0 minute et le substrat étant exposé au plasma au silane et à l'ammoniaque combinés pendant environ 2,8 minutes.

14. Procédé selon l'une quelconque des revendications précédentes, caractérisé en ce que le revêtement de polysilazane a une vitesse d'attaque chimique relativement rapide dans un réactif d'attaque tamponné tel qu'une solution d'HF et de $NH_4F$ avant qu'il ne soit chauffé et une vitesse d'attaque chimique relativement lente dans le même réactif d'attaque tamponné après qu'il a été chauffé.

15. Procédé selon la revendication 14, caractérisé en ce que le revêtement de polysilazane a une vitesse d'attaque de $4,0 \times 10^{-9}$ à $10,0 \times 10^{-9}$/minute (40 à 100 angströms/minute) dans le réactif d'attaque tamponné avant qu'il n'ait été chauffé et une vitesse d'attaque chimique de $2,0 \times 10^{-9}$ m/minute ou moins (20 angströms par minute ou moins) après qu'il a été chauffé.

STARTING MATERIAL

2 — | P |

N⁺ DIFFUSION

2 — | P | 8 / 6 / 4 / 4A / 6A
8A

GLASS ETCH

2 — | P | 6 / 4 / 4A / 6A

SILICON NITRIDE DEPOSITION

2 — | P | 10 / 4 / 4A / 6A

PHOTORESIST COATING

2 — | P | 12 / 10 / 4 / 4A / 6A

PHOTORESIST EXPOSURE AND DEVELOPMENT

2 — | P | 12A / 10 / 4 / 4A / 6A

FINGER ETCH

12A | P | 12A / 10 / 10 / 4 / 4A / 6A
2 — 10

RESIST REMOVAL

2 — | P | 10A / 6 / 4 / 4A / 6A

ALUMINUM DEPOSITION

2 — | P | 10A / 10A / 4 / 4A / 6A / 14

ALUMINUM ALLOYING

2 — | P | 10A / 6 / 4 / 16 / 14

NICKEL PLATING

2 — | 20 / 10A / 20 | P | 10A / 6 / 4 / 16 / 14
18

NICKEL ETCHING

2 — | P / 20 / 10A | 6 / 4 / 16 / 14
18

SECOND NICKEL PLATING

2 — | 20 / P / 10A | 6 / 4 / 16 / 14
18

11